# EUROPEAN PATENT SPECIFICATION

(11) **EP 0 784 714 B1**
(45) Date of publication and mention of the grant of the patent: **04.11.1998**
(21) Application number: 95932855.0
(22) Date of filing: 03.10.1995
(51) Int. Cl.: C23C 16/26, G02B 1/10

(54) **LOW SURFACE ENERGY COATINGS**
BESCHICHTUNGEN MIT NIEDRIGER OBERFLÄCHENENERGIE
REVETEMENTS POSSEDANT UNE TENSION DE SURFACE REDUITE

(30) Priority: 05.10.1994 GB 9420089
(43) Date of publication of application: 23.07.1997
(73) Proprietor: APPLIED VISION LIMITED, Whitwick, Leicestershire LE67 4JP (GB)
(72) Inventor: WALLS, John, Michael, Whitwick Leicestershire LE67 4JP (GB); SPENCER, Alaric Graham, Whitwick Leicestershire LE67 4JP (GB); WAUGH, Allen Robert, Whitwick Leicestershire LE67 4JP (GB); WHITE, Norman Henry, Whitwick Leicestershire LE67 4JP (GB); SOUTHWORTH, Paul, Whitwick Leicestershire LE67 4JP (GB)
(74) Representative: Wood, Graham
(86) International application number: GB9502339
(87) International publication number: WO9611289

(56) References cited:
- EP-A- 0 454 995
- WO-A-92/13114
- WO-A-94/03331
- DE-A- 3 316 693
- DE-A- 4 211 962
- US-A- 4 444 805
- PATENT ABSTRACTS OF JAPAN vol. 013 no. 007 (P-810) ,10 January 1989 & JP,A,63 214701 (NIKON CORP) 7 September 1988,

## Description

The present invention relates to a method and apparatus for applying a layer of material to form a low surface energy coating and typically, but not exclusively a coating for a substrate in the form of an optical lens to provide an outer layer having a low surface energy.

In the coating of substrates such as optical lens it is appreciated that in order to provide an outer surface of the same with the desired surface characteristic of low surface energy, an outer layer of suitable material is required to be applied once the conventional coating processes are completed. The desired quality of the outer surface is that it has a low surface energy such that any material or liquids which contact with the surface during use of the lens can be relatively easily removed. If the surface energy of the outer surfaces of the lens is too high then material tends to "stick" to and be attracted to the surface. This tendency to stick causes materials such as liquids or grease to smear when attempts are made to remove the same. Repeated smearing leads to a reduction in the optical quality of the lens and is generally undesirable.

The recognised method for measuring surface energy is to measure the hydrophobic characteristic of the surface by analysing the contact angle of a drop of pure water on the surface. The shape of the water drop and the angle between the surface and the tangent of the water drop is called the contact angle and is related to the surface energy. It is desired that the water contact angle be greater than 70 degrees to be acceptable for optical use. In general, the greater the angle the lower the surface energy. By achieving the desired contact angle the lenses are more easily cleaned and the layer reduces the friction of the outer surface and hence reduces the propensity for the lens to be scratched. This is an especially important consideration with regard to plastic lenses.

Conventionally, in order to apply the required coating onto the optical lens either of two methods are currently used. The first method requires the lens, once all other coating operations have been completed, to be dipped into a coating mixture and either wiped clean or then placed into an oven where the same are baked, typically for 10 minutes, at a temperature of 50 degrees Celsius. In this process when the lens are dipped care is required to ensure that the lens are evenly coated with the liquid coating. This possibility of uneven coating is exacerbated by the fact that the coating is typically applied by a manual operation, and the time required for the dipping and baking process make this method undesirable to users. Furthermore the solutions which are used, age, even when refrigerated, and reach a point where the viscosity is so high that the layer applied to the lens is too thick and causes an optical change in the reflection colour which is not uniform and appears as a smear. Even the addition of a solvent to reduce the viscosity cannot prevent the eventual need to discard the material. The material used is also relatively expensive.

An alternative method which is known is to prepare a liquid of a composition which, if applied to the lens to provide the outer coating, provides the low surface energy properties required. In this case the liquid is applied to the lens when the lens are held within the apparatus in which the previous optical coatings have been applied. The liquid is heated externally of the apparatus and the vapour produced passed through supply pipes into the chamber. When the vapour is provided a plasma source in the chamber is operated to crack the vapour into chemical groupings and the required groupings condense on the lens to provide a low surface energy coating. However, once again, the time required for this coating operation is prohibitive as the liquid must first be heated to the required temperature to produce the vapour and the vapour is simultaneously supplied to the chamber. Furthermore, problems are caused by the vapour condensing in the supply means from the heated liquid to the chamber thus causing blockage and/or a reduction in the efficiency of cracking of the vapour which is produced. If the condensation becomes too great it is necessary for the supply means to be dismantled, cleaned and dried.

Other apparatus known includes that of DE4211962 which discloses a plasma assisted CVD process which uses, preferably microwaves for generating plasma for depositing a low surface energy coating having a thickness of below 20 angstroms or of greater than 100 angstroms on substrates such as headlight reflectors. No magnetically enhanced plasma source is disclosed or suggested in this patent and therefore is not applicable to the current use. The apparatus of Patent Abstracts of Japan, Volume 13, No. 7(P-810), reveals the coating of lenses with a hard, thin film of carbon with a thickness of under 100 angstroms by a plasma CVD, ion plating, ion beam or a sputtering process but again no magnetically enhanced plasma source is disclosed or suggested and neither of these documents provide for a contact angle of at least 68°.

EP0454995 discloses a plasma CVD process for coating ink jet head components with hydrogenated amorphous carbon in thickness of about 1,000 angstroms. Again no magnetically enhanced plasma source is disclosed or suggested.

WO9213114 discloses a sputtering apparatus for coating lenses comprising at least one magnetron preferably two metal targets in a chamber and a means for reacting the coatings. However there is no disclosure in this patent of the application of low surface energy coatings to the substrate or the use of such apparatus in any form so as to achieve the formation of the low surface energy coatings.

The aim of the present invention is to provide a method and apparatus for providing a coating with low surface energy properties on optical lens efficiently and as an integral part of an integral part of the lens coating process.

The present invention provides, in a first aspect a method for forming a low surface energy coating having water contact angle of at least 68° on the surface of an optical lens, said method comprising placing the lens in a chamber, forming a vacuum in the chamber, providing a fluid to the chamber to be introduced into the chamber as a gas containing hydrocarbon groupings and characterised in that the chamber incorporates a magnetically enhanced plasma source which is activated when the gas containing the hydrocarbon groupings is introduced into the chamber to split at least some hydrocarbon groupings from the gas until and at least some of said groupings applied to the surface of the optical lens to produce a low surface energy coating thereon.

Preferably, sufficient gas is supplied and hydrocarbon groupings split to provide a coating to a depth of 0.1 - 5 nanometers. A coating of this depth will not substantially affect the optical quality of the lens.

Typically the plasma source is any of an ion source, plasma source, unbalanced magnetron source or glow discharge means operable by any of d.c., a.c. or r.f. power means, mounted to be operable within the vacuum chamber to split the hydrocarbon groupings from the gas.

Preferably the gas introduced into the chamber is a hydrocarbon such as methane or propane. Secondary gases such as hydrogen, argon or oxygen may also be introduced into the chamber along with the hydrocarbon gas. Typically the gas is diluted, prior to final compression to atmospheric pressure by the vacuum pumps, in an inert gas such as nitrogen or argon or in air. A typical dilution range for methane in air is less than 5% by volume.

Typically the time taken for application of the outer coating is between 1-5 minutes. The low surface energy property of the coating is measured by analysing the hydrophobic characteristics of the same. Typically the contact angle of a drop of pure water when methane is used is in the region of 76-90 degrees and 68-72 degrees with propane.

In a further aspect of the invention there is provided a method of coating an optical lens comprising the steps of introducing at least one optical lens into a chamber, said chamber containing at least one magnetron with a metal target, and a plasma source, pulling a vacuum in the chamber, activating the magnetron to sputter a metal onto the lens surface, introducing oxygen into the chamber and activating the plasma source to chemically react the metal to provide the required optical coating on the lens, wherein the method comprises the further step of switching off the magnetrons, plasma source and gas supply, introducing a gas containing hydrocarbon groupings into the chamber and activating the plasma source to split at least some hydrocarbon groupings from the gas and deposit the same on the lens to form an outer surface coating having low surface energy characteristics.

Typically the method includes activating two magnetrons, each having a target of different metal to produce a multilayered optical coating on the lens prior to the introduction of the gas containing hydrocarbon groupings.

In a further aspect of the invention there is provided apparatus for the coating of optical lenses, said apparatus comprising a chamber, an optical lens holder within the chamber, a means for pulling a vacuum in the chamber, at least one magnetron with a metal target and a plasma source, drive means for moving optical lens on the holder passed the magnetron and plasma source and control means for activating the magnetron and plasma source, and characterised in that the apparatus further comprises a source for gas containing hydrocarbon groupings and supply means for introducing the gas into the chamber and, when said plasma source is operated when the gas is introduced, to split at least some hydrocarbon groupings from said gas in the chamber.

Typically the gas source is a conventional gas bottle and the supply means include a control device for controlling the supply of the gas from the bottle into the chamber. Preferably the control device is, in turn, operated by the control means for the activation of the plasma source and magnetrons. Typically the control system is operated by a central computer processor.

The supply means preferably allow the gas to be diluted in an inert gas such as argon or nitrogen, or in air prior to final compression to atmospheric pressure by the vacuum pumps and the supply means includes a combustible gas sensor, flow meter or other means to monitor the level of dilution.

The gas source and gas supply means can be included for use with conventional optical lens coating apparatus and operation of the same is included as an integral part of the process for providing a complete coating of the optical lens.

In a further aspect of the invention the method of applying an outer coating having low surface energy properties to optical lenses includes the further steps of applying a gas containing groupings other than hydrocarbon groupings to further increase the water contact angle achieved. In one instance a halogen containing gas such as CF4, C2F6, CCl4 is applied and creates a fluorinated or chlorinated surface. In an alternative instance a silicon containing gas such as tetraethoxysilane, tetramethoxysilane, hexamethyldisiloxane is applied to create a silicone layer.

Specific embodiments of the invention are now disclosed with reference to the accompanying drawings wherein;
Figure 1 illustrates a plan view of one embodiment of a chamber for the application of coatings to optical lens by sputter deposition of material; and
Figure 2 illustrates a schematic representation of the components of the invention.
Figure 3 illustrates a cross sectional view of an optical lens coated according to the present invention.

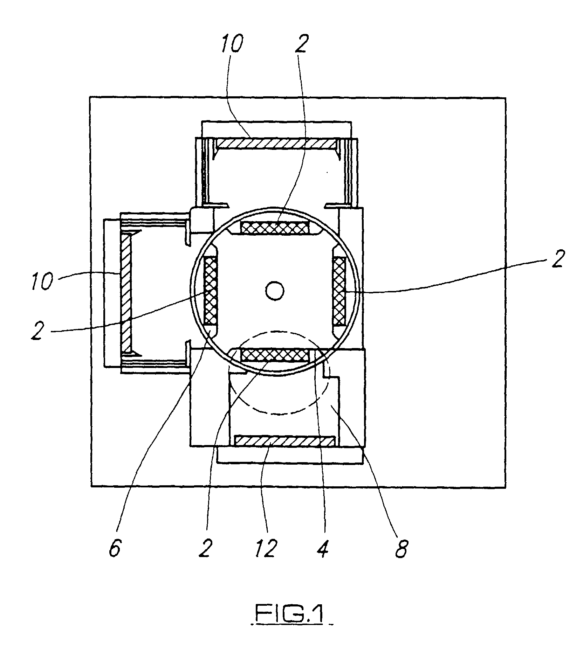

Referring firstly to Figure 1 there is shown a representation of one type of chamber which is currently used for the application of coatings to optical lens. It should be appreciated that chambers having differing geometries are equally relevant to the invention disclosed herein and that reference to Figure 1 is for clarification purposes only.

Figure 1 discloses apparatus for coating optical lens 2 held on a rotatable holder 4 within a chamber 6. The chamber is connected to a vacuum pump 8, the operation of which creates a vacuum in the chamber 6. At points around the walls of the chamber, apertures are provided to allow the inclusion of two magnetrons 10 and a plasma source 12. Each magnetron 10 contains a target of a metal and activation of the magnetrons causes sputtering of particles of metal into the chamber 6 and onto the optical lens 2 held on the rotating holder to coat the same. At the same time oxygen is supplied into the chamber and the plasma source, in this case an unbalanced magnetron, is operated to form a metal oxide coating on the optical lens. Thus alternate operation of the magnetrons 10 provides a multilayered metal coating on the surfaces of the optical lens and this method and apparatus is currently used to provide lenses with multilayered coatings to provide the required optical effect.

At this stage the outer surface of the lenses have been found to be susceptible to smearing and to the gathering of dust and grease due to the relatively high surface energy of the surfaces. This is unacceptable and these lenses are then typically removed from the apparatus and dipped in a liquid outer coating mixture and baked to provide the required low surface energy outer coating. This represents an additional and wasteful coating operation.

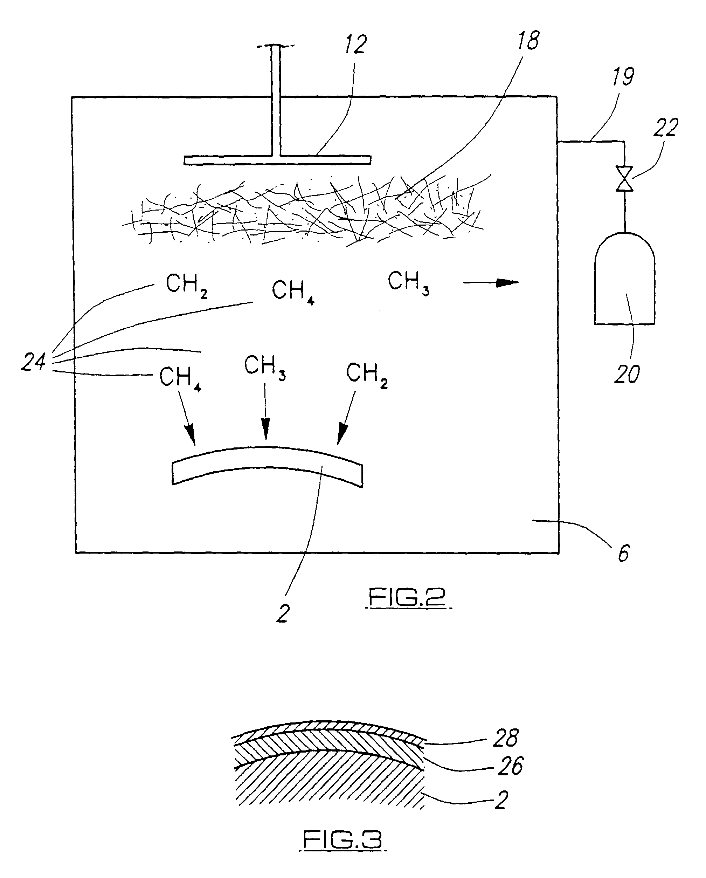

Figure 2 illustrates in schematic form the further apparatus and operations which are performed on the lenses in situ in the chamber and apparatus of Figure 1 according to the present invention. In the figure there is shown a plasma source 12 which is provided to operate in the vacuum chamber 6. After the lenses 2 have been coated using conventional apparatus as disclosed in Figure 1 and using, in this case, metal targets in magnetrons, these magnetrons are stopped and the plasma source 12 activated to create a plasma 18 in the chamber. At this time gas supply means 19 are activated by the apparatus control system to supply a hydrocarbon gas/ air or inert gas mixture into the chamber 6. The gas supply means comprise a gas bottle 20 and a delivery control means 22 which may also comprise a gas monitor(not shown).

When the gas is introduced into the chamber 6 to be exposed to the plasma 18 at least some of the hydrocarbon groupings, here represented by the numeral 24, split from the gas. The separated groupings then settle on the walls of the chamber and the optical lens 2 to provide the required coating on outer surface of the lens. The duration of the method described above is determined on the volume and speed of gas supply and the required thickness of coating.

Figure 3 illustrates a cross section of an optical lens 2 which has been coated in the manner disclosed above and the cross section or "stack" of coatings consists of a conventional multi layer anti reflective coating 26 applied by conventional methods and an outer "hydrophobic" layer 28 having the required low surface energy characteristics applied by the methods and apparatus of this invention.

Thus, in normal operation, once the multilayered coatings have been applied to the optical lenses to provide the required optical effect, the control system of the apparatus serves to stop the plasma source and oxygen supply and the operation of the magnetrons 10. The gas containing hydrocarbon groupings is then introduced into the chamber and the plasma source 12 activated to cause separation of at least some hydrocarbon groupings in the gas. The separated groupings are then free to land on available surfaces in the chamber including the surfaces of the optical lenses held therein. Thus the outer surfaces of the optical lenses are coated with a relatively thin (typically 0.1-5 nanometres) coating of the hydrocarbon groupings.

The coating applied provides lenses with outer surfaces which have sufficiently low surface energy characteristics to be significantly less susceptible to smearing and the attraction of foreign matter.

Tests have shown that the following operating parameter conditions of the method of the invention provide an outer coating on the lens which has the required hydrophobic test qualities without affecting the optical quality of the lens. The power of the plasma source is typically held between 15 and 25 Watts and the voltage at 600V. In this case methane is introduced at a pressure of 5 10(-3) mBar and the lens is exposed for around 1 minute. This has been found to provide a coating on the lenses which, when tested with a drop of pure water thereon, provides a water drop contact angle of 89 degrees thus achieving the required low surface energy characteristics.

The apparatus and method of the current invention provides a means whereby an outer coating can be applied to optical lenses to reduce the surface energy of the surface to within required parameters and said coating can be applied as an integral part of the conventional coating process and apparatus. Thus the quality and speed of application of this outer coating is significantly improved and can be controlled to provide an improved quality coating.

## Claims

1. A method for forming a low surface energy coating having a water contact angle of at least 68° on the surface of an optical lens, said method comprising placing the lens in a chamber, forming a vacuum in the chamber, providing a fluid to the chamber to be introduced into the chamber as a gas containing hydrocarbon groupings and characterised in that the chamber incorporates a magnetically enhanced plasma source which is activated when the gas containing the hydrocarbon groupings is introduced into the chamber to split at least some hydrocarbon groupings from the gas and at least some of said groupings applied to the surface of the optical lens to produce a low surface energy coating thereon.

2. A method according to claim 1 characterised in that sufficient gas is supplied and hydrocarbon groupings split to provide a coating to a depth of 0.1 to 5 nanometers on said optical lens.

3. A method according to claim 1 characterised in that the plasma source is any of an ion source, plasma source, unbalanced magnetron source or a low discharge means operable by any of d.c, a.c or r.f power means.

4. A method according to claim 1 characterised in that the gas introduced into the chamber is hydrocarbon such as methane or propane.

5. A method according to claim 4 characterised in that the gas is diluted in an inert gas or air.

6. A method according to claim 5 characterised in that the gas is methane and the dilution range for methane in air is less than 5% by volume.

7. A method according to claim 6 wherein the contact angle of a drop of pure water on the surface when methane is used is in the region of 76-90°.

8. A method according to claim 5 characterised in that the contact angle of a drop of pure water on the surface when propane is used is 68-72°.

9. A method of coating an optical lens comprising the steps of introducing at least one optical lens into a chamber, said chamber containing at least one magnetron with a target of metal therein, and a plasma source, pulling a vacuum in the chamber, activating the magnetron to sputter a metal onto the lens surface, introducing oxygen into the chamber and activating the plasma source to chemically react the material to provide the required optical coating on the lens, characterised in that the method includes a further step of switching off the at least one magnetron, plasma source and gas supply, introducing a gas containing hydrocarbon groupings into the chamber and activating the plasma source to split at least some hydrocarbon groupings from the gas and deposit the same onto the lens to form an outer coating thereon.

10. A method according to claim 9 characterised in that two magnetrons are activated, each having a target of different metal to produce a multilayered optical coating on the lens prior to the introducing of the gas containing hydrocarbon groupings.

11. A method according to any of the preceding claims characterised in that the method includes the further step of applying a gas containing groupings other than hydrocarbon groupings.

12. A method according to claim 11 characterised in that a halogen containing gas such as CF4, C2F6, CCl4 is applied and creates a fluorinated or chlorinated surface.

13. A method according to claim 11 characterised in that a silicon containing gas such as tetraethoxysilane, tetramethoxysilane, hexamethyldisiloxane is applied to create a silicon surface layer.

14. Apparatus for the coating of optical lenses, said apparatus comprising a chamber, an optical lens holder within the chamber, a means for pulling a vacuum in the chamber, at least one magnetron with a metal target and a plasma source, drive means for moving optical lens on the holder past the magnetron and plasma source and control means for activating the magnetron and plasma source, and characterised in that the apparatus further comprises a source for gas containing hydrocarbon groupings and supply means for introducing the gas into the chamber and, when said plasma source is operated when the gas is introduced, to split at least some hydrocarbon groupings from said gas in the chamber.

15. Apparatus according to claim 14, characterised in that the gas source is a conventional gas bottle and the supply means include a control device for controlling the supply of the gas from the bottle into the chamber.

16. Apparatus according to claim 15 characterised in that the control device is in turn operated by the control means for the activation of the plasma source and magnetron.

17. Apparatus according to any of claims 14 to 16 characterised in that the supply means allows the gas to be diluted in an inert gas, or in air, prior to final compression to atmospheric pressure by the vacuum pump.

18. Apparatus according to any of claims 14 to 17 characterised in that the supply means includes a combustible gas sensor, flow meter or other means to monitor the level of dilution.

## Patentansprüche

1. Verfahren zum Formen einer Schicht mit niedriger Oberflächenenergie, die einen Wasserkontaktwinkel von wenigstens 68° hat, auf der Oberfläche einer optischen Linse, wobei das genannte Verfahren die folgenden Schritte umfaßt: Legen der Linse in eine Kammer, Erzeugen eines Vakuums in der Kammer, Liefern eines Fluids zu der Kammer, das als Gas in die Kammer eingeleitet wird, das Kohlenwasserstoffgruppierungen enthält, dadurch gekennzeichnet, daß die Kammer eine magnetisch verstärkte Plasmaquelle einschließt, die aktiviert wird, wenn das Gas mit den Kohlenwasserstoffgruppierungen in die Kammer eingeleitet wird, um wenigstens einige Kohlenwasserstoffgruppierungen von dem Gas abzuspalten, und wenigstens einige der genannten Gruppierungen auf die Oberfläche der optischen Linse aufgetragen werden, um darauf eine Schicht mit niedriger Oberflächenenergie zu erzeugen.

2. Verfahren nach Anspruch 1, dadurch gekennzeichnet, daß genügend Gas geliefert und Kohlenwasserstoffgruppen abgespalten werden, um eine Schicht mit einer Dicke von 0,1 bis 5 Nanometer auf der genannten optischen Linse zu bilden.

3. Verfahren nach Anspruch 1, dadurch gekennzeichnet, daß die Plasmaquelle eine Ionenquelle, eine Plasmaquelle, eine unsymmetrische Magnetronquelle oder eine Niedrigentladungsvorrichtung ist, die über ein Gleichstrom-, Wechselstrom- oder Funkwellenleistungsmittel betrieben werden kann.

4. Verfahren nach Anspruch 1, dadurch gekennzeichnet, daß das in die Kammer eingeführte Gas ein Kohlenwasserstoff wie Methan oder Propan ist.

5. Verfahren nach Anspruch 4, dadurch gekennzeichnet, daß das Gas in einem inerten Gas oder Luft verdünnt wird.

6. Verfahren nach Anspruch 5, dadurch gekennzeichnet, daß das Gas Methan ist und der Verdünnungsbereich für Methan in Luft weniger als 5 Vol.-% beträgt.

7. Verfahren nach Anspruch 6, bei dem der Kontaktwinkel eines Tropfens reinen Wassers auf der Oberfläche im Bereich zwischen 76 und 90° liegt, wenn Methan verwendet wird.

8. Verfahren nach Anspruch 5, dadurch gekennzeichnet, daß der Kontaktwinkel eines Tropfens reinen Wassers auf der Oberfläche bei 68 bis 72° liegt, wenn Propan verwendet wird.

9. Verfahren zum Beschichten einer optischen Linse, umfassend die folgenden Schritte: Einführen von wenigstens einer optischen Linse in eine Kammer, wobei die genannte Kammer wenigstens ein Magnetron mit einem Metall-Target darin und eine Plasmaquelle enthält, Erzeugen eines Vakuums in der Kammer, Aktivieren des Magnetrons, um ein Metall auf die Linsenoberfläche zu sputtern, Einführen von Sauerstoff in die Kammer und Aktivieren der Plasmaquelle, um das Material in chemische Reaktion zu bringen, um die erforderliche optische Schicht auf der Linse zu bilden, dadurch gekennzeichnet, daß das Verfahren ferner die folgenden Schritte umfaßt: Abschalten des wenigstens einen Magnetrons, der Plasmaquelle und der Gasversorgung, Einleiten eines Gases, das Kohlenwasserstoffgruppierungen enthält, in die Kammer und Aktivieren der Plasmaquelle, um wenigstens einige Kohlenwasserstoffgruppierungen von dem Gas abzuspalten und diese auf die Linse aufzubringen, um darauf eine Außenschicht zu bilden.

10. Verfahren nach Anspruch 9, dadurch gekennzeichnet, daß zwei Magnetrone aktiviert werden, wobei jedes über ein Target aus einem anderen Metall verfügt, um eine mehrlagige optische Schicht auf der Linse zu erzeugen, bevor das Gas, das Kohlenwasserstoffgruppierungen enthält, eingeleitet wird.

11. Verfahren nach einem der vorherigen Ansprüche, dadurch gekennzeichnet, daß das Verfahren ferner das Verwenden eines Gases umfaßt, das andere Gruppierungen als Kohlenwasserstoffgruppierungen enthält.

12. Verfahren nach Anspruch 11, dadurch gekennzeichnet, daß ein halogenhaltiges Gas wie CF4, C2F6, CCl4 verwendet wird und eine fluorierte oder chlorierte Oberfläche erzeugt.

13. Verfahren nach Anspruch 11, dadurch gekennzeichnet, daß ein siliciumhaltiges Gas wie Tetraethoxysilan, Tetramethoxysilan, Hexamethyldisiloxan verwendet wird, um eine Siliciumoberflächenschicht zu erzeugen.

14. Vorrichtung zum Beschichten optischer Linsen, wobei die genannte Vorrichtung folgendes umfaßt: eine Kammer, einen optischen Linsenhalter in der Kammer, ein Mittel zum Erzeugen eines Vakuums in der Kammer, wenigstens ein Magnetron mit einem Metall-Target und einer Plasmaquelle, Antriebsmittel zum Bewegen der optischen Linse auf dem Halter an dem Magnetron und der Plasmaquelle vorbei und Steuermittel zum Aktivieren des Magnetrons und der Plasmaquelle, dadurch gekennzeichnet, daß die Vorrichtung ferner eine Quelle für Gas, das Kohlenwasserstoffgruppierungen enthält, und ein Zuführmittel zum Einführen des Gases in die Kammer umfaßt, um wenigstens einige Kohlenwasserstoffgruppierungen von dem genannten Gas in der Kammer abzuspalten, wenn die genannte Plasmaquelle beim Einleiten des Gases betrieben wird.

15. Vorrichtung nach Anspruch 14, dadurch gekennzeichnet, daß die Gasquelle eine konventionelle Gasflasche ist und das Zuführmittel ein Steuermittel zum Steuern der Zufuhr des Gases aus der Flasche in die Kammer enthält.

16. Vorrichtung nach Anspruch 15, dadurch gekennzeichnet, daß das Steuergerät wiederum von dem Steuermittel für die Aktivierung der Plasmaquelle und des Magnetrons betrieben wird.

17. Vorrichtung nach einem der Ansprüche 14 bis 16, dadurch gekennzeichnet, daß das Zuführmittel das Gas in einem inerten Gas oder in Luft verdünnen läßt, bevor die letzte Verdichtung auf atmosphärischen Druck durch die Vakuumpumpe stattfindet.

18. Vorrichtung nach einem der Ansprüche 14 bis 17, dadurch gekennzeichnet, daß das Zufuhrmittel einen Brenngassensor, einen Strömungsmesser oder ein anderes Mittel zur Überwachung des Verdünnungsgrades enthält.

## Revendications

1. Une méthode destinée à former un revêtement possédant une tension de surface réduite dont l'angle de contact avec l'eau est au moins égal à 68° sur la surface d'une lentille optique, ladite méthode comprenant les étapes suivantes, à savoir positionnement de la lentille dans une chambre, création du vide dans la chambre, acheminement d'un fluide à la chambre qui sera introduit dans la chambre sous la forme d'un gaz contenant des groupements d'hydrocarbures, et caractérisée en ce que la chambre comporte une source plasma à enrichissement magnétique laquelle est activée au moment où le gaz contenant les groupements d'hydrocarbures est introduit dans la chambre afin de fractionner au moins quelques-uns des groupements d'hydrocarbures du gaz, et au moins quelques-uns desdits groupements sont appliqués sur la surface de la lentille optique dans le but de produire un revêtement possédant une tension de surface réduite sur celle-ci.

2. Une méthode, selon les stipulations de la revendication 1, caractérisée en ce qu'un volume de gaz suffisant est fourni et qu'un nombre suffisant de groupements d'hydrocarbures est fractionné pour produire un revêtement jusqu'à une profondeur située entre 0,1 à 5 nanomètres sur ladite lentille optique.

3. Une méthode, selon les stipulations de la revendication 1, caractérisée en ce que la source plasma peut être l'une quelconque d'une source ionique, d'une source plasma, d'une source à magnétron en déséquilibre, ou d'un dispositif à faible décharge capable de fonctionner en conjonction avec un équipement à énergie c.c., ou a.c. ou r.f.

4. Une méthode, selon les stipulations de la revendication 1, caractérisée en ce que le gaz introduit dans la chambre est un hydrocarbure, par exemple le méthane ou le propane.

5. Une méthode, selon les stipulations de la revendication 4, caractérisée en ce que le gaz est dilué dans un gaz inerte ou dans de l'air.

6. Une méthode, selon les stipulations de la revendication 5, caractérisée en ce que le gaz est du méthane et la gamme de dilution pour le méthane dans l'air est inférieure à 5% par volume.

7. Une méthode, selon les stipulations de la revendication 6, dans laquelle l'angle de contact d'une goutte d'eau pure sur la surface, dans le cas de l'utilisation du méthane, est de l'ordre de 76 à 90°.

8. Une méthode, selon les stipulations de la revendication 5, caractérisée en ce que l'angle de contact d'une goutte d'eau pure sur la surface, dans le cas de l'utilisation du propane, est de 68 à 72°.

9. Une méthode de revêtement d'une lentille optique comprenant les étapes consistant à introduire au moins une lentille optique dans une chambre, ladite chambre contenant au moins un magnétron avec une cible en métal, et une source plasma, à créer le vide dans la chambre, à activer le magnétron en vue de la pulvérisation du métal sur la surface de la lentille, à introduire de l'oxygène dans la chambre et à activer la source plasma afin de faire réagir chimiquement le matériau pour produire le revêtement optique requis sur la lentille, caractérisée en ce que la méthode comporte une étape supplémentaire consistant à mettre hors circuit au moins un magnétron, une source plasma et une alimentation en gaz, à introduire dans la chambre un gaz contenant des groupements d'hydrocarbures, à activer la source plasma afin de fractionner au moins quelques-uns des groupements d'hydrocarbures du gaz et à déposer ceux-ci sur la lentille dans le but de former un revêtement externe sur celle-ci.

10. Une méthode, selon les stipulations de la revendication 9, caractérisée en ce que deux magnétrons sont activés, chacun ayant une cible de métal différent pour produire un revêtement optique multicouches sur la lentille, avant d'introduire le gaz contenant les groupements d'hydrocarbures.

11. Une méthode, selon les stipulations de l'une quelconque des revendications précédentes, caractérisée en ce que la méthode comporte une étape supplémentaire consistant à injecter un gaz contenant des groupements différents des groupements d'hydrocarbures.

12. Une méthode, selon les stipulations de la revendication 11, caractérisée en ce qu'un gaz contenant des halogènes, par exemple CF4, C2F6, CCl4, est injecté et produit une surface fluorurée ou chlorurée.

13. Une méthode, selon les stipulations de la revendication 11, caractérisée en ce qu'un gaz contenant du silicium, par exemple le tétraéthoxysilane, le tétraméthoxysilane ou l'hexaméthyldisiloxane, est injecté afin de produire une couche de silicium sur la surface.

14. Un équipement destiné au revêtement des lentilles optiques, ledit équipement comprenant une chambre, un support de lentille optique dans la chambre, un dispositif pour créer le vide dans la chambre, au moins un magnétron avec une cible métal et une source plasma, un dispositif d'entraînement pour faire passer la lentille optique sur le support devant le magnétron et la source plasma, et un moyen de commande destiné à activer le magnétron et la source plasma, et caractérisé en ce que l'équipement comprend une source pour le gaz contenant des groupements d'hydrocarbures et un dispositif d'alimentation pour injecter le gaz dans la chambre et, lorsque ladite source plasma est activée, afin de fractionner au moins quelques-uns des groupements d'hydrocarbures dudit gaz présent dans la chambre au moment où le gaz est injecté.

15. Un équipement, selon les stipulations de la revendication 14, caractérisé en ce que le gaz se présente sous la forme d'une bouteille classique, et le dispositif d'alimentation comporte un dispositif de contrôle pour surveiller le débit du gaz sortant de la bouteille pour se rendre dans la chambre.

16. Un équipement, selon les stipulations de la revendication 15, caractérisé en ce que le dispositif de contrôle est, à son tour, actionné par le moyen de commande utilisé pour l'activation de la source plasma et du magnétron.

17. Un équipement, selon les stipulations de l'une quelconque des revendications 14 à 16, caractérisé en ce que le dispositif d'alimentation permet la dilution du gaz dans un gaz inerte, ou dans l'air, avant sa compression finale à la pression atmosphérique par la pompe à vide.

18. Un équipement, selon les stipulations de l'une quelconque des revendications 14 à 17, caractérisé en ce que le dispositif d'alimentation comprend un capteur de gaz combustible, un débitmètre ou tout autre instrument pour mesurer le niveau de dilution.
